Europäisches Patentamt

European Patent Office

Office européen des brevets

(19)

(11) Publication number: **0 081 060**
**A2**

(12) **EUROPEAN PATENT APPLICATION**

(21) Application number: **82109297.0**

(22) Date of filing: **07.10.82**

(51) Int. Cl.³: **H 03 H 1/00**

(30) Priority: **27.11.81 IT 3405281 U**

(43) Date of publication of application:
**15.06.83 Bulletin 83/24**

(84) Designated Contracting States:
**AT BE CH DE FR GB IT LI NL SE**

(71) Applicant: **DUCATI ELETTROTECNICA SpA**
**Via Marco E. Lepido 178**
**I-40132 Bologna(IT)**

(72) Inventor: **De Faveri, Americo**
**Via Campelli**
**I-32013 Longarone (Belluno)(IT)**

(72) Inventor: **Zanvettor, Sergio**
**Via Di Sopra 54**
**I-32010 Ospitale di Cadore (Belluno)(IT)**

(72) Inventor: **Savi, Antonio**

**I-32013 Dogna di Longarone (Belluno)(IT)**

(74) Representative: **Patentanwälte Grünecker, Dr.**
**Kinkeldey, Dr. Stockmair, Dr. Schumann, Jakob, Dr.**
**Bezold, Meister, Hilgers, Dr. Meyer-Plath**
**Maximilianstrasse 58**
**D-8000 München 22(DE)**

(54) **Noise suppressing filter having a plurality of capacitors within a single coil.**

(57) A capacitive filter of the single-coil type comprises a continuous metallic layer and a discontinuous metallic layer separated from one another by a dielectric layer and forming a plurality of capacitors having at least one common plate. The opposing plates of said capacitors are formed by respective portions of said discontinuous metallic layer and are each provided with a terminal projecting from one end face of the coil. In order to avoid the occurrence of parasitic inductances in the windings of the continuous metallic layer, the invention provides that at least a certain number of the windings of said continuous metallic layer projects from the opposite end face of the coil, the projecting portions of said windings being interconnected by a short-circuiting member.

Fig. 1

EP 0 081 060 A2

Noise Suppressing Filter Having a Plurality of Capacitors Within a Single Coil

D e s c r i p t i o n

This invention relates to a filter for suppressing radiofrequency noises of the type comprising a plurality of capacitors formed in a single winding or coil.

Known filters of this type generally comprise at least two capacitors of the so-called Y class, adapted to be connected between respective phases of the electric power supply and ground for suppressing asymmetric disturbances or noise. In addition, such filters are usually provided with at least one capacitor of the so-called X class adapted to be connected between the phases of the electric power supply for suppressing symmetric disturbances. Filters of the above defined type may be designed for obtaining capacitive circuits of different configurations in accordance with specific requirements.

It is known to construct such filters with a single coil comprising a continuous metallic layer and a discontinuous metallic layer separated from one another by a dielectric layer. In this manner it is possible to obtain a certain number of individual capacitors, for instance three such capacitors having a common first plate constituted by the continuous metallic layer, and a second plate consisting of respective portions of the discontinuous metallic layer. For ensuring complete electric insulation, the width of the dielectric layer is greater than that of the metallic layers, the latter being suitably provided with pin type contact terminals projecting from one end face of the coil in axial direction. Preferably only the portions of the discontinuous metallic layer are provided with such terminals for connection to ground and to the phases of the electric power supply, respectively.

The single-coil capacitive filters of this type are of a simple and compact construction, they have an inherent disadvantage, however, in the occurrence of parasitic inductances due to the fact that the continuous metallic layer is formed to a considerable number of windings. The parasitic inductances thus occur in the common plate of the three capacitors and exert a negative influence on the functions of the capacitive filter. These negative influences can become inacceptable in the case that the currents involved are of particularly high frequencies.

According to the present invention, there is provided a capacitive filter of the single-coil type, comprising a continuous metallic layer and a discontinuous metallic layer separated from one another by a dielectric layer and forming a plurality of capacitors having at least one common plate. The opposing plates of said capacitors are formed by respective portions of the discontinuous metallic layer and are each provided with a terminal projecting from one end face of the coil. This filter is characterized by the fact that at least a certain number of the windings of said continuous metallic layer projects from the opposite end face of said coil, the projecting portions of said windings being interconnected by a short-circuiting member.

The capacitive filter according to the invention, while retaining a simple and compact construction, is capable of minimizing the parasitic inductances occurring in the common plate of the capacitors by short-circuiting at least a certain number of the windings thereof.

Further characteristics and advantages of the invention will become evident from the following description of an exemplary embodiment with reference to the accompanying drawings, wherein:

fig. 1 shows a perspective view of a capacitive filter in an embodiment of the invention,

fig. 2 shows in diagrammatic form a developed view of
    the filter of fig. 1, and

fig. 3 shows an electric circuit diagram of the filter
    of fig. 1.

Referring now to the figures of the drawings, the capacitive filter according to the invention is of the type
comprising a single coil 4. This coil is formed of a
continuous metallic layer 5, covered by a dielectric
layer 6 having a longitudinally discontinuous metallic
layer 7 disposed thereon. In addition there is provided
a further dielectric layer 12 acting as an insulation
between the windings of metallic layers 5 and 7 and for
the outer periphery of coil 4. The metallic layers 5, 7
may be formed of aluminum sheets the width of which is
smaller than that of the dielectric layers 6 and 12.

In the embodiment shown, the discontinuous metallic
layer 7 comprises three separate portions each provided
with a pin-type connection terminal 8, 9, 10 affixed
thereto on a per se known manner and projecting from
one end face of coil 4 in an axial direction.

The three separate portions of discontinuous metallic
layer 7 cooperate with continuous metallic layer 5 to
form three capacitors having a common plate constituted
by continuous metallic layer 5.

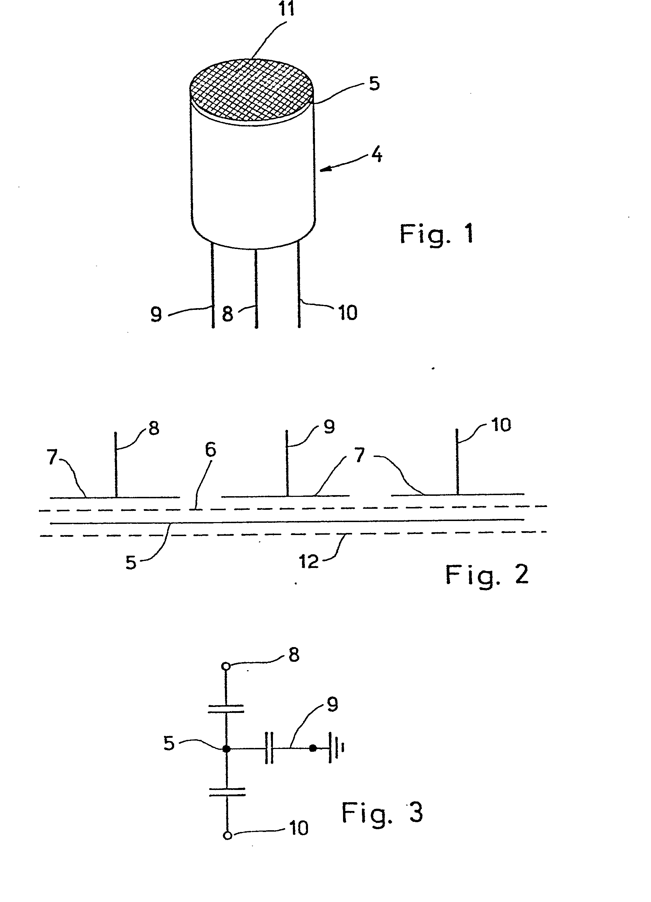

Terminals 8 and 10 of the filter are adapted to be connected to respective phases of an AC power supply, while
terminal 9 is adapted to be connected to ground, as shown
in fig. 3.

The relative great number of windings of continuous metallic layer 5 gives rise to the occurrence of parasitic inductances, as explained above, which in the circuit shown in fig. 3 may be considered to be connected in series to each of the capacitors through the common plate 5.

In accordance with the invention, continuous metallic layer 5 projects for a certain axial length from the and face of coil 4 opposite to the end face from which terminals 8, 9 and 10 project. Projecting in this manner are at least a certain number of the windings of layer 5, preferably, however, the continuous metallic layer 5 so projects over its full length. The projecting windings of metallic layer 5 can be readily short-circuited as by means of an aluminum layer 11, so as to practically eliminate any parasitic inductances and to thereby attain the object of the invention.

The described capacitive filter may of course be modified in various manners. It may thus include any suitable number of capacitors having a common plate. In another modification, the metallic layer 5 may also be divided into two or mor sections each forming at least one capacitor with corresponding portions of metallic layer 7, so as to obtain any number of X-class and Y-class capacitors in a single coil 4. Obviously in this case only the common plate of the Y-class capacitors will be short-circuited.

GRÜNECKER, KINKELDEY, STOCKMAIR & PARTNER

PATENTANWÄLTE
EUROPEAN PATENT ATTORNEYS

A GRUNECKER. DIPL -ING
DR H KINKELDEY DIPL -ING
DR W STOCKMAIR. DIPL -ING. AE E ICALTECH
DR K SCHUMANN. DIPL -PHYS
P H JAKOB. DIPL -ING
DR G BEZOLD. DIPL -CHEM
W. MEISTER. DIPL -ING
H HILGERS. DIPL -ING
DR H MEYER-PLATH. DIPL -ING

8000 MÜNCHEN 22
MAXIMILIANSTRASSE 43

**0081060**

EP 759

## Noise Suppressing Filter Having a Plurality of Capacitors Within a Single Coil

### P a t e n t   C l a i m

1. Capacitive filter of the type having a single coil, comprising a continuous metallic layer and a discontinuous metallic layer separated by a dielectric layer and forming a plurality of capacitors having at least one common plate, the opposing plates of said capacitors being formed by respective portions of the discontinuous metallic layer and provided with terminals projecting from one end face of said coil, <u>characterized in that</u> at least a certain number of the windings of said continuous metallic layer (5) projects from the opposite end face of said coil (4), the projecting portions of said windings being interconnected by a short-circuiting member (11).

Fig. 1

Fig. 2

Fig. 3